# EUROPÄISCHE PATENTSCHRIFT

(11) **EP 1 559 111 B1**
(45) Veröffentlichungstag und Bekanntmachung des Hinweises auf die Patenterteilung: **08.08.2007**
(21) Anmeldenummer: 03769246.4
(22) Anmeldetag: 16.10.2003
(51) Int. Cl.: G11C 16/10

(54) **VERFAHREN ZUM BETREIBEN EINER SPEICHERANORDNUNG**
METHOD FOR OPERATING A MEMORY ARRANGEMENT
PROCEDE DE FONCTIONNEMENT D'UN ENSEMBLE MEMOIRE

(30) Priorität: 08.11.2002 DE 10252059
(43) Veröffentlichungstag der Anmeldung: 03.08.2005
(73) Patentinhaber: Infineon Technologies AG, 81669 München (DE)
(72) Erfinder: DIRSCHERL, Gerd, 81549 München (DE); PETERS, Christian, 85591 Vaterstetten (DE); SEDLAK, Holger, 82054 Sauerlach (DE)
(74) Vertreter: Epping - Hermann - Fischer
(86) Internationale Anmeldenummer: PCT/DE2003/003437
(87) Internationale Veröffentlichungsnummer: WO 2004/042740

(56) Entgegenhaltungen:
- US-A- 5 337 275
- US-A- 5 357 475
- US-A- 5 896 393
- US-A1- 2001 049 764

## Beschreibung

Die vorliegende Erfindung betrifft ein Verfahren zum Betreiben einer Speicheranordnung.

Zahlreiche Anwendungen, wie beispielsweise tragbare Datenträger, mobile Datenverarbeitung, drahtlose Daten- und Energieübertragung sowie sicherheitsrelevante Einrichtungen erfordern bei der Programmierung von Daten, daß der ursprüngliche Inhalt einer Speicherzelle bei Ausfall oder Abschaltung der Stromversorgung während der Programmierung erhalten bleibt.

Derzeit gebräuchliche elektrisch lösch- und programmierbare nichtflüchtige Halbleiterspeicher sind die sogenannten EEPROMS (Electrically Erasable and Programmable Read Only Memories) oder Flash-Speicher bzw. FLASH-EEPROMs. Derartige Speichereinrichtungen weisen eine hohe Speicherzellendichte auf und sind jederzeit elektrisch lösch- oder umprogrammierbar. Die Speichereinrichtungen sind dabei in der Regel in eine Anzahl von Sektoren unterteilt. Diese Sektoren werden wiederum in eine Vielzahl von Seiten unterteilt.

In EEPROMS können die Daten seitenweise in einzelnen Segmenten der Seiten abgespeichert werden. Zum Löschen dieser Daten werden diese segmentweise markiert. Ein Flash-Speicher kann nur seitenweise programmiert werden, während ein EEPROM aufgrund seines Aufbaus eine wesentlich geringere Granularität aufweist. Bei einem Flash-Speicher werden zu löschende Daten markiert, wobei jedoch nur seitenweise gelöscht werden, wie z. B. in dem US Patent US 5 404 485.

Zur Programmierung von Daten eines Flash-Speichers wird eine Kopie der Daten einer oder mehrerer Speicherseiten in einen weiteren Speicher geladen. Zum Abspeichern der Daten werden die vorab kopierten Daten einer Speicherseite gelöscht und die programmierten Daten auf dieser Seite gespeichert. Spannungseinbrüche bzw. Ausfall oder Abschaltung der Stromversorgung während der Programmierung können zu einem Abbruch eines Programmier- oder Löschvorgangs führen. Somit besteht die Möglichkeit, daß nach einem erfolgten Löschvorgang die ursprünglichen Daten gelöscht sind und aufgrund eines eintretenden Stromausfalls auch die Datenkopie im Arbeitsspeicher nicht mehr zur Verfügung steht.

Zumindest der Anmelderin ist bekannt, daß zur Vermeidung eines Datenverlustes bzw. undefinierter Datenzustände aufgrund eines Stromausfalls (tearing-sichere Programmierung) bei der Programmierung von Daten aufwendige Algorithmen angewandt werden, die mehrere Lösch- und Programmierzyklen beinhalten, wobei eine doppelt bis vierfache Programmierzeit benötigt wird.

Aufgabe der vorliegenden Erfindung ist es, ein einfaches und schnelles Verfahren zum Betreiben einer Speicheranordnung anzugeben, bei dem eine "tearing-sichere Programmierung" von Daten einer Speichereinrichtung ermöglicht ist, so daß nach erfolgter Programmierung bei einem Stromausfall auf die ursprünglichen Daten weiterhin zugegriffen werden kann.

Diese Aufgabe wird erfindungsgemäß durch die Merkmale des Anspruchs 1 gelöst, wobei vorteilhafte Ausgestaltungen in den Unteransprüchen angegeben sind.

Bei dem erfindungsgemäßen Verfahren zum Betreiben einer Speicheranordnung umfaßt die Speicheranordnung einen nichtflüchtigen Speicher, zum Beispiel einen Flash-Speicher, und eine Adressübersetzungseinheit, zum Beispiel einen Arbeitsspeicher, wobei der nichtflüchtige Speicher Speicherseiten und zumindest eine zusätzliche Speicherseite aufweist, die über physikalische Adressen adressierbar sind. In der Adressübersetzungseinheit werden den vom Prozessor logisch adressierbaren Adressen die physikalischen Adressen der Speicherseiten des Flash-Speichers zugeordnet. In der Adressübersetzungseinheit werden die logischen Adressen in physikalische Adressen übersetzt, so daß ein schneller Zugriff auf die Speicherseiten erfolgen kann.'In einem nicht adressierbaren Bereich der Speicherseiten des Flash-Speichers werden zum einen die den physikalischen Adressen einer Speicherseite zugeordneten logischen Adressen abgespeichert, zum anderen ein Zähler mitgeführt. Zur Programmierung einer adressierten Speicherseite wird eine Kopie der Daten und eine Kopie der Daten des nicht adressierbaren Bereichs in einen weiteren Speicher zur Bearbeitung kopiert und der Zähler der Datenkopie um eins erhöht. Nach Beendigung der Programmierung wird die bearbeitete Kopie der Daten und die Daten des nicht adressierbaren Bereichs in der zusätzlichen Speicherseite gespeichert.

Dadurch, daß die programmierten Daten auf der zusätzlichen Speicherseite abgespeichert werden, müssen die ursprünglichen Daten nicht vor dem Abspeichern der programmierten Daten gelöscht werden. Erst nach dem Abspeichern der programmierten Daten können die ursprünglichen Daten auf der Speicherseite gelöscht werden. Die Speicherseite nimmt anschließend die Funktion einer zusätzlichen Speicherseite ein. Weiterhin erfolgt eine Zuordnung der physikalischen Adresse der zusätzlichen Speicherseite an die Stelle der der adressierten Speicherseite zugeordneten logischen Adresse in der Adressübersetzungseinheit.

Besonders vorteilhaft ist es, daß die Daten nach erfolgter Programmierung weiterhin auf der Speicherseite und die veränderten Daten auf der zusätzlichen Speicherseite vorliegen und aufgrund ihres unterschiedlichen Zählerwertes im nicht adressierbaren Bereich unterscheidbar sind. Hierin zeigt sich der besondere Vorteil des erfindungsgemäßen Verfahrens. Eine Unterbrechung der Stromzufuhr zum Zeitpunkt der Programmierung der Daten hat keine Auswirkungen auf die ursprünglichen Daten, so daß ein Zugriff auf diese weiterhin gewährt bleibt. Wurden die Daten bei einer Unterbrechung der Stromzufuhr bereits auf der zusätzlichen Speicherseite gespeichert, werden bei einer erneuten Stromzufuhr sektorweise die im nicht adressierbaren Bereich einer Speicherseite und im nicht adressierbaren Bereich der zusätzlichen Speicherseite gespeicherten logischen Adressen der zugehörigen physikalischen Adressen der Speicherseite bzw. zusätzlichen Speicherseite ausgewertet. Den logischen Adressen der Adressübersetzungseinheit werden die vorab ausgewerteten physikalischen Adressen der Speicherseiten zugeordnet. Werden zwei Speicherseiten mit unterschiedlicher physikalischer Adresse und mit einer übereinstimmenden logischen Adresse festgestellt, so wird nur diejenige physikalische Adresse einer Speicherseite der entsprechenden logischen Adresse in der Adressübersetzungseinheit zugeordnet, die im nicht adressierbaren Bereich einen höheren Zählerstand aufweist.

Ein weiterer besonderer Vorteil ergibt sich bei dem erfindungsgemäßen Verfahren dadurch, daß ein Flash-Speicher bei der Programmierung die Granularität eines EEPROMS aufweist. Dadurch daß die veränderten Daten in der zusätzlichen Speicherseite des nichtflüchtigen Speichers abgespeichert werden, sind bei einer Unterbrechung der Stromzufuhr nur die veränderten Daten betroffen, so daß auf alle Daten der Speicherseite weiterhin zugriffen werden kann.

Nachfolgend wird die Erfindung anhand eines Ausführungsbeispiels mit Bezugnahme auf die Figuren näher erläutert. Gleiche oder sich entsprechende Elemente in verschiedenen Figuren sind mit gleichen Bezugszeichen versehen.

Es zeigen:
Figur 1 eine Speicheranordnung zur Durchführung des erfindungsgemäßen Verfahrens,
Figur 2a ein Ausführungsbeispiel eines Sektors eines nichtflüchtigen Speichers,
Figur 2b ein Ausführungsbeispiel einer Adressübersetzungseinheit,
Figur 2c eine Speicherseite eines nichtflüchtigen Speichers,
Figur 2d der Inhalt der Speicherseite gemäß Figur 2 in einem weiteren Speicher,
Figur 2e eine weitere Speicherseite eines nichtflüchtigen Speichers nach der Programmierung,
Figur 2f die Adressübersetzungseinheit nach der Programmierung der Speicherseite und
Figur 2g die Speicherseiten des nichtflüchtigen Speichers nach der Programmierung.

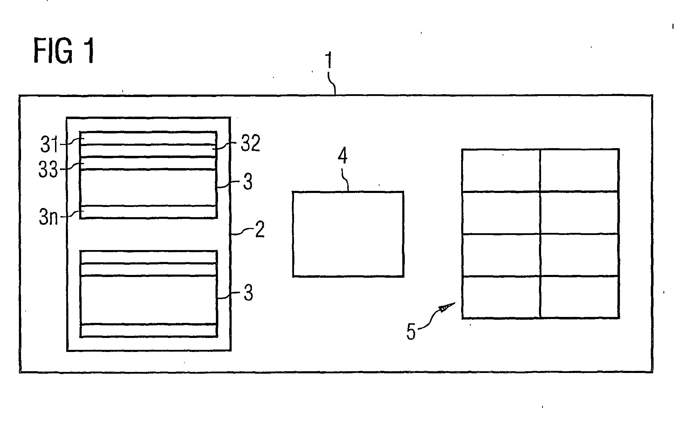

Figur 1 zeigt eine Speicheranordnung 1 zur Durchführung des erfindungsgemäßen Verfahrens. Die Speicheranordnung 1 umfaßt einen nichtflüchtigen Flash-Speicher 2, einen weiteren Speicher 4 und eine Adressübersetzungseinheit 5. Der nichtflüchtige-Flash-Speicher 2 ist in Sektoren 3 unterteilt, die ihrerseits physikalische Speicherseiten 31, 32, 33 und 3n aufweisen. In der Adressübersetzungseinheit 5 ist jeder physikalischen Adresse der Speicherseiten 31, 32, 33 und 3n des nichtflüchtigen Speichers 2 eine logische Adresse der Speicherseiten 31, 32, 33 und 3n zugeordnet. Die durch einen hier nicht dargestellten Prozessor adressierte logische Adresse wird von der Adressübersetzungseinheit 5 in die physikalische Adresse übersetzt, so daß ein schneller Zugriff auf die entsprechende Speicherseite 31, 32, 33 und 3n des nichtflüchtigen Speichers 2 erfolgen kann. Die logische Adresse einer Speicherseite in der Adressübersetzungseinheit 5 kann hierbei eine variable Bitbreite aufweisen, wobei eine bestimmte Anzahl an Bits zur Adressierung verwendet wird, während die verbleibende Anzahl an Bits für Fehlererkennung oder weitere hier nicht relevante Funktionen eingesetzt werden kann.

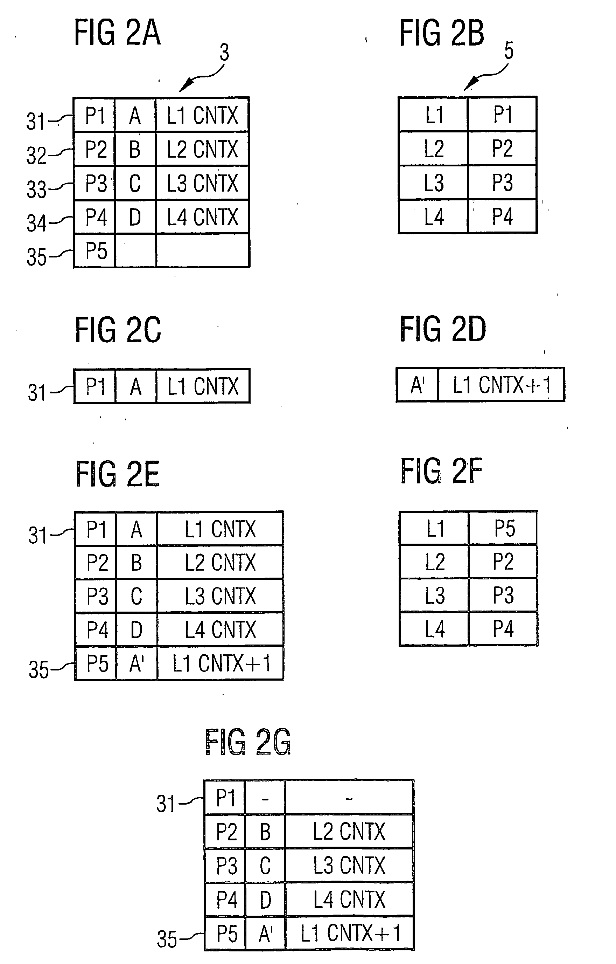

Die Figur 2a zeigt ein Ausführungsbeispiel eines Sektors 3 des nichtflüchtigen'Speichers 2. Der Sektor 3 des nichtflüchtigen Speichers 2 weist die Speicherseiten 31, 32, 33, 34 und 35 auf. In der Spalte 1 repräsentieren die Variablen P1, P2, P3, P4 und P5 die physikalischen Adressen der jeweiligen Speicherseite 31, 32, 33, 34 und 35, in der Spalte 2 stehen die Variablen A, B, C und D für die in den Speicherseiten 31, 32, 33 und 34 gespeicherten Daten. In der Spalte 3 ist ein nicht adressierbarer Bereich dargestellt, der sich in diesem Ausführungsbeispiel in den Seitenbereichen des nichtflüchtigen Speichers 2 befindet. Der nicht adressierbare Bereich ist nicht auf den nichtflüchtigen Speicher 2 beschränkt und kann sich somit in einem beliebigen Speicher befinden. In diesem nicht adressierbaren Bereich sind für jede Speicherseite die in der Adressübersetzungseinheit 5 der physikalischen Adresse dieser Speicherseite zugeordneten logischen Adresse und ein Zähler vorzufinden. Die logischen Adressen werden durch die Variablen L1, L2, L3, L4 und L5 und der Zähler durch die Variable CNTX repräsentiert. Die in den Zeilen 1 bis 4 des Sektors 3 dargestellten Speicherseiten 31, 32, 33 und 34 sind durch den Prozessor adressierbar, während die Speicherseite 35 in der Zeile 5 eine zusätzliche Speicherseite repräsentiert, die von dem Prozessor nicht angesprochen werden kann. Sie enthält weiterhin keine adressierbaren Daten und keine Daten im nicht adressierbaren Bereich.

Ein der Übersetzung der logischen Adressen in die physikalischen Adressen der Speicherseiten des nichtflüchtigen Speichers 2 dienende Adressübersetzungseinheit 5 ist in Figur 2b dargestellt. Den logisch adressierbaren Adressen L1, L2, L3, L4 und L5 der ersten Spalte sind in jeder Zeile die physikalische Adressen P1, P2, P3 P4 und P5 der Spalte 2 der Speicherseiten des nichtflüchtigen Speichers 2 zugeordnet.

Wie eine Programmierung der Daten der Speicherseiten des nichtflüchtigen Speichers 2 vorteilhaft erfolgt, wird unter Bezugnahme auf die Figuren 2c bis 2f erläutert.

In Figur 2c ist die erste Speicherseite des nichtflüchtigen Speichers 2 gemäß Figur 2a, Zeile 1 dargestellt. Zur Programmierung werden die Daten A der Spalte 2 und die logische Adresse sowie der Zähler des nicht adressierbaren Bereich in einen weiteren Speicher 4 kopiert, wobei der Zähler um eins erhöht wird und veränderte Daten A' im weiteren Speicher 4 gemäß Figur 2d vorliegen. Nach einer erfolgreichen Programmierung werden die veränderten Daten A' in einer zusätzlichen Speicherseite des nichtflüchtigen Speichers 2 abgespeichert, so daß sowohl die Originaldaten A als auch die veränderten Daten A' in dem nicht füchtigen Speicher verfügbar sind.

Wie in Figur 2e dargestellt, befinden sich die Originaldaten A nach wir vor in der Speicherseite 31 der zweiten Spalte der ersten Zeile. Die veränderten Daten A' sind in der zusätzlichen Speicherseite 35 in der zweiten Spalte der fünften Zeile verfügbar. Dadurch daß zur Programmierung ebenfalls die Daten des nicht adressierbaren Bereichs kopiert wurden, weisen die beiden Speicherseiten 31 und 35 des nichtflüchtigen Speichers 2 in der dritten Spalte eine übereinstimmende logische Adresse L1 auf. Sie unterscheiden sich jedoch in der Höhe des Zählwertes des Zählers CNTX und CNTX+1 in der dritten Spalte.

Eine Unterbrechung der Stromversorgung hat zur Folge, daß die Zuordnungen der logischen Adressen L1, L2, L3 und L4 zu den physikalischen Adressen P1, P2, P3, P4 und P5 der Speicherseiten 31, 32, 33, 34 und 35 in der Adressübersetzungseinheit 5 neu aufgebaut werden. Hierzu wird die logische Adresse L1, L2, L3 und L4 im nicht adressierbaren Bereich sowie die physikalische Adresse P1, P2, P3, P4 und P5 der jeweiligen Speicherseite 31, 32, 33, 34 und 35 ausgewertet und die physikalische Adresse P1, P2, P3, P4 und P5 der jeweiligen logischen Adresse L1, L2, L3 und L4 in der Adressübersetzungseinheit 5 zugeordnet. Für den Fall, daß zwei Speicherseiten und somit zwei physikalische Adressen eine übereinstimmende logische Adresse aufweisen,'wird der Zählwert der Zähler der beiden Speicherseiten verglichen und diejenige physikalische Adresse der Speicherseite mit dem höheren Zählwert des Zählers der logischen Adresse in der,Adressübersetzungseinheit 5 zugeordnet.

Die Zuordnung der Adressen in der Adressübersetzungseinheit 5 nach erfolgter Programmierung ist in Figur 2f dargestellt.
Da die veränderten Daten A' in der zusätzlichen Speicherseite 35 gemäß Figur 2e abgespeichert wurden, wurde die neue physikalische Adresse P5 der zusätzlichen Speicherseite 35 des nichtflüchtigen Speichers 2 in die zweite Spalte der ersten Zeile des Arbeitsspeichers 5 übernommen, so daß bei einer Adressierung der logischen Adresse L1 die Adressübersetzungseinheit 5 diese in die physikalische Adresse P5 übersetzt und die Daten A' aus der zusätzlichen Speicherseite 35 gelesen werden können.

Wie in der ersten Zeile der Figur 2g dargestellt, sind nach erfolgter Programmierung die Daten der Speicherseite 31 ungültig gemacht worden, so daß für einen nachfolgenden Programmiervorgang diese Speicherseite 31 als zusätzliche Speicherseite dient.

### Bezugszeichenliste

- 1: Speicheranordnung
- 2: Nichtflüchtiger Speicher
- 3: Sektoren
- 31: Speicherseite
- 32: Speicherseite
- 33: Speicherseite
- 34: Speicherseite
- 35: Speicherseite
- 3n: Speicherseite
- 4: Weiterer Speicher
- 5: Arbeitsspeicher
- CNTX: Zähler
- L1: Logische Adresse
- L2: Logische Adresse
- L3: Logische Adresse
- L4: Logische Adresse
- P1: Physikalische Adresse
- P2: Physikalische Adresse
- P3: Physikalische Adresse
- P4: Physikalische Adresse
- P5: Physikalische Adresse
- A: Daten
- A': Veränderte Daten

## Patentansprüche

1. Verfahren zum Betreiben einer Speicheranordnung (1), die einen nichtflüchtigen Speicher (2) und zumindest eine Adressübersetzungseinheit (5) umfaßt, der nichtflüchtige Speicher (2) Speicherseiten (31, 32, 33, 34) und zumindest eine zusätzliche Speicherseite (35) aufweist, die Speicherseiten (31, 32, 33, 34) und die zusätzliche Speicherseite (35) physikalische Adressen (P1, P2, P3, P4, P5) aufweisen, in der Adressübersetzungseinheit (5) logisch adressierbare Adressen (L1, L2, L3, L4) in die physikalischen Adressen (P1, P2, P3, P4, P5) der Speicherseiten (31, 32, 33, 34) und der zusätzlichen Speicherseite (35) übersetzt werden,
**dadurch gekennzeichnet, daß**
- im nichtflüchtigen Speicher (2) in den Speicherseiten (31, 32, 33, 34) und in der zusätzlichen Speicherseite (35) innerhalb eines nicht adressierbaren Bereichs Daten, die eine Adressübersetzung ermöglichen, abgespeichert werden,
- zur Programmierung einer Speicherseite (31, 32, 33, 34) eine Kopie der Daten und eine Kopie der Daten des nicht adressierbaren Bereichs in einen weiteren Speicher (4) zur Bearbeitung abgelegt wird und die Daten im nicht adressierbaren Bereich verändert werden und
- nach Beendigung der Programmierung die bearbeitete Kopie der Daten und die veränderten Daten des nicht adressierbaren Bereichs in der zusätzlichen Speicherseite (35) gespeichert werden.

2. Verfahren nach Anspruch 1,
**dadurch gekennzeichnet, daß**
die Daten im nicht adressierbaren Bereich der Speicherseiten (31, 32, 33, 34) und der zusätzlichen Speicherseite (35) des nichtflüchtigen Speichers (2) den physikalischen Adressen (P1, P2, P3, P4, P5) der Speicherseiten (31, 32, 33, 34) und
der zusätzlichen Speicherseite (35) zugeordneten logischen Adressen (L1, L2, L3, L4) entsprechen und einen Zähler (CNTX) aufweisen.

3. Verfahren nach Anspruch 1 oder 2,
**dadurch gekennzeichnet, daß**
die Daten des nicht adressierbaren Bereichs bei der Programmierung einer Speicherseite (31, 32, 33, 34) verändert werden, indem der Zähler (CNTX) um eins erhöht wird.

4. Verfahren nach einem der vorherigen Ansprüche,
**gekennzeichnet durch**
eine Programmierung in den folgenden Schritten:
a. Speichern der Daten in der adressierten Speicherseite (31, 32, 33, 34) und der bearbeiteten Kopie der Daten in der zusätzlichen Speicherseite (35), wobei die Speicherseite (31, 32, 33, 34) und die zusätliche Speicherseite (35) in einem nicht adressierbaren Bereich eine übereinstimmende logische Adresse (L1, L2, L3, L4) und die Speicherseite (31, 32, 33, 34) und die zusätliche Speicherseite (35) in einem nicht adressierbaren Bereich einen unterschiedlichen Zählerstand des Zählers (CNTX) aufweisen,
b. Ungültigmachen der Daten sowie der Daten des nicht adressierbaren Bereichs der adressierten Speicherseite (31, 32, 33, 34) und
c. Zuordnen der physikalischen Adresse (P5) der zusätzlichen Speicherseite (35) an die Stelle der der adressierten Speicherseite (31, 32, 33, 34) zugeordneten logischen Adresse (L1, L2, L3, L4) in der Adressübersetzungseinheit (5).

5. Verfahren nach Anspruch 1 oder 4,
**dadurch gekennzeichnet, daß**
die adressierte Speicherseite (31, 32, 33, 34) nach erfolgter Programmierung zur zusätzlichen Speicherseite (35) wird.

6. Verfahren nach Anspruch 1,
**dadurch gekennzeichnet, daß**
der nichtflüchtige Speicher (2) ein Flaph-Speicher ist.

7. Verfahren nach Anspruch 1,
**dadurch gekennzeichnet, daß**
die Adressübersetzungseinheit (5) ein Arbeitsspeicher ist.

8. Verfahren nach einem der vorherigen Ansprüche,
**dadurch gekennzeichnet, daß**
- der nichtflüchtige Speicher (2) in Sektoren (3) aufgeteilt ist und eine festgelegte Anzahl an physikalischen Speicherseiten (31, 32, 33, 34, 35) aufweist,
- nach einer Unterbrechung der Stromzufuhr sektorweise die, im nicht adressierbaren Bereich der Speicherseite (31, 32, 33, 34) und im nicht adressierbaren Bereich der zusätzlichen Speicherseite (35) gespeicherten logischen Adressen (L1, L2, L3, L4) der zugehörigen physikalischen Adressen (P1, P2, P3, P4, P5) der Speicherseite (31, 32, 33, 34) bzw. zusätzlichen Speicherseite (35) ausgewertet werden,
- den logischen Adressen (L1, L2, L3, L4) der Adressübersetzungseinheit (5) die vorab ausgewerteten physikalischen Adressen (P1, P2, P3, P4, P5) der Speicherseiten (31, 32, 33, 34) bzw. zusätzlichen Speicherseite (35) zugeordnet werden und
- bei Vorhandensein von zwei Speicherseiten (31, 32, 33, 34) bzw. zusätzlichen Speicherseite (35) mit einer übereinstimmenden logischen Adresse (L1, L2, L3, L4) nur diejenige physikalische Adresse (P1, P2, P3, P4, P5) der Speicherseite (31, 32, 33, 34) bzw. zusätzlichen Speicherseite (35) der entsprechenden logischen Adresse (L1, L2, L3, L4) in der Adressübersetzungseinheit (5) zugeordnet wird, die im nicht adressierbaren Bereich einen höheren Zählerstand des Zählers (CNTX) aufweist.

## Claims

1. Method for operating a memory arrangement (1) comprising a nonvolatile memory (2) and at least one address translation unit (5), the nonvolatile memory (2) having memory pages (31, 32, 33, 34) and at least one additional memory page (35), the memory pages (31, 32, 33, 34) and the additional memory page (35) having physical addresses (P1, P2, P3, P4, P5), logically addressable addresses (L1, L2, L3, L4) being translated into the physical addresses (P1, P2, P3, P4, P5) of the memory pages (31, 32, 33, 34) and of the additional memory page (35) in the address translation unit (5),
**characterized in that**
- data which make address translation possible are stored within an unaddressable area in the memory pages (31, 32, 33, 34) and in the additional memory page (35) in the nonvolatile memory (2),
- for the purposes of programming a memory page (31, 32, 33, 34), a copy of the data and a copy of the data of the unaddressable area are stored in a further memory (4) for processing and the data in the unaddressable area are changed, and
- once programming has been completed, the processed copy of the data and the changed data of the unaddressable area are stored in the additional memory page (35).

2. Method according to Claim 1,
**characterized in that**
the data in the unaddressable area of the memory pages (31, 32, 33, 34) and of the additional memory page (35) of the nonvolatile memory (2) correspond to the logical addresses (L1, L2, L3, L4) assigned to the physical addresses (P1, P2, P3, P4, P5) of the memory pages (31, 32, 33, 34) and of the additional memory page (35), and have a counter (CNTX).

3. Method according to Claim 1 or 2,
**characterized in that**
the data of the unaddressable area are changed during the programming of a memory page (31, 32, 33, 34) by the counter (CNTX) being incremented by one.

4. Method according to one of the preceding claims,
**characterized by**
programming in the following steps:
a. storage of the data in the addressed memory page (31, 32, 33, 34) and storage of the processed copy of the data in the additional memory page (35), the memory page (31, 32, 33, 34) and the additional memory page (35) having a matching logical address (L1, L2, L3, L4) in an unaddressable area, and the memory page (31, 32, 33, 34) and the additional memory page (35) having a different reading of the counter (CNTX) in an unaddressable area,
b. invalidation of the data and also of the data of the unaddressable area of the addressed memory page (31, 32, 33, 34), and
c. assignment of the physical address (P5) to the additional memory page (35) in the place of the logical address (L1, L2, L3, L4), which has been assigned to the addressed memory page (31, 32, 33, 34), in the address translation unit (5).

5. Method according to Claim 1 or 4,
**characterized in that**
the addressed memory page (31, 32, 33, 34) becomes the additional memory page (35) after programming has been carried out.

6. Method according to Claim 1,
**characterized in that**
the nonvolatile memory (2) is a flash memory.

7. Method according to Claim 1,
**characterized in that**
the address translation unit (5) is a main memory.

8. Method according to one of the preceding claims,
**characterized in that**
- the nonvolatile memory (2) is divided into sectors (3) and has a fixed number of physical memory pages (31, 32, 33, 34, 35),
- following an interruption in the power supply, the logical addresses (L1, L2, L3, L4) of the associated physical addresses (P1, P2, P3, P4, P5) of the memory page (31, 32, 33, 34) and additional memory page (35) (said logical addresses being stored in the unaddressable area of the memory page (31, 32, 33, 34) and in the unaddressable area of the additional memory page (35)) are evaluated sector by sector,
- the previously evaluated physical addresses (P1, P2, P3, P4, P5) of the memory pages (31, 32, 33, 34) and additional memory page (35) are assigned to the logical addresses (L1, L2, L3, L4) of the address translation unit (5), and
- if there are two memory pages (31, 32, 33, 34) and an additional memory page (35), respectively, having a matching logical address (L1, L2, L3, L4), only that physical address (P1, P2, P3, P4, P5) of the memory page (31, 32, 33, 34) or additional memory page (35) which has a higher reading of the counter (CNTX) in the unaddressable area is assigned to the corresponding logical address (L1, L2, L3, L4) in the address translation unit (5).

## Revendications

1. Procédé d'exploitation d'un système de mémoire (1) qui comprend une mémoire non volatile (2) et au moins une unité de conversion d'adresse (5), la mémoire non volatile (2) comportant des pages de mémoire (31, 32, 33, 34) et au moins une page de mémoire supplémentaire (35), les pages de mémoire (31, 32, 33, 34) et la page de mémoire supplémentaire (35) comportant des adresses physiques (P1, P2, P3, P4, P5) et des adresses logiquement adressables (L1, L2, L3, L4) étant converties dans l'unité de conversion d'adresse (5) en adresses physiques (P1, P2, P3, P4, P5) des pages de mémoire (31, 32, 33, 34) et de la page de mémoire supplémentaire (35),
**caractérisé par le fait que**
- on mémorise dans la mémoire non volatile (2), dans les pages de mémoire (31, 32, 33, 34) et dans la page de mémoire supplémentaire (35), à l'intérieur d'une zone non adressable, des données qui permettent une conversion d'adresse,
- pour la programmation d'une page de mémoire (31, 32, 33, 34), on enregistre une copie des données et une copie des données de la zone non adressable dans une autre mémoire (4) en vue de leur traitement et on modifie les données dans la zone non adressable, et
- après la fin de la programmation, on mémorise la copie traitée des données et les données modifiées de la zone non adressable dans la page de mémoire supplémentaire (35).

2. Procédé selon la revendication 1,
**caractérisé par le fait que** les données dans la zone non adressable des pages de mémoire (31, 32, 33, 34) et de la page de mémoire supplémentaire (35) de la mémoire non volatile (2) correspondent à des adresses logiques (L1, L2, L3, L4) associées aux adresses physiques (P1, P2, P3, P4, P5) des pages de mémoire (31, 32, 33, 34) et de la page de mémoire supplémentaire (35) et comportent un compteur (CNTX).

3. Procédé selon la revendication 1 ou 2,
**caractérisé par le fait que** l'on modifie les données de la zone non adressable lors de la programmation d'une page de mémoire (31, 32, 33, 34) en augmentant le compteur (CNTX) de un.

4. Procédé selon l'une des revendications précédentes,
**caractérisé par** une programmation selon les étapes suivantes :
a. mémorisation des données dans la page de mémoire adressée (31, 32, 33, 34) et mémorisation de la copie traitée des données dans la page de mémoire supplémentaire (35), la page de mémoire (31, 32, 33, 34) ainsi que la page de mémoire supplémentaire (35) comportant dans une zone non adressable une adresse logique coïncidente (L1, L2, L3, L4) et la page de mémoire (31, 32, 33, 34) ainsi que la page de mémoire supplémentaire (35) comportant dans une zone non adressable un état différent du compteur (CNTX),
b. invalidation des données ainsi que des données de la zone non adressable de la page de mémoire adressée (31, 32, 33, 34), et
c. association de l'adresse physique (P5) à la page de mémoire supplémentaire (35) à la place de l'adresse logique (L1, L2, L3, L4), associée à la page de mémoire adressée (31, 32, 33, 34), dans l'unité de conversion d'adresse (5).

5. Procédé selon la revendication 1 ou 4,
**caractérisé par le fait que**, une fois la programmation effectuée, la page de mémoire adressée (31, 32, 33, 34) devient la page de mémoire supplémentaire (35).

6. Procédé selon la revendication 1,
**caractérisé par le fait que** la mémoire non volatile (2) est une mémoire flash.

7. Procédé selon la revendication 1,
**caractérisé par le fait que** l'unité de conversion d'adresse (5) est une mémoire de travail.

8. Procédé selon l'une des revendications précédentes,
**caractérisé par le fait que**
- la mémoire non volatile (2) est divisée en secteurs (3) et comporte un nombre fixé de pages de mémoire physiques (31, 32, 33, 34, 35),
- après une interruption de l'alimentation en courant, on évalue secteur par secteur les adresses logiques (L1, L2, L3, L4), mémorisées dans la zone non adressable de la page de mémoire (31, 32, 33, 34) et dans la zone non adressable de la page de mémoire supplémentaire (35), des adresses physiques associées (P1, P2, P3, P4, P5) de la page de mémoire (31, 32, 33, 34) et de la page de mémoire supplémentaire (35),
- on associe aux adresses logiques (L1, L2, L3, L4) de l'unité de conversion d'adresse (5) les adresses physiques préalablement évaluées (P1, P2, P3, P4, P5) des pages de mémoire (31, 32, 33, 34) et de la page de mémoire supplémentaire (35), et
- en présence de deux pages de mémoire (31, 32, 33, 34) et page de mémoire supplémentaire (35) ayant une adresse logique coïncidente (L1, L2, L3, L4), on associe seulement celle des adresses physiques (P1, P2, P3, P4, P5) de la page de mémoire (31, 32, 33, 34) ou page de mémoire supplémentaire (35) qui a un état supérieur du compteur (CNTX) dans la zone non adressable à l'adresse logique correspondante (L1, L2, L3, L4) dans l'unité de conversion d'adresse (5).
